# EUROPÄISCHE PATENTSCHRIFT

(11) **EP 2 943 630 B1**
(45) Veröffentlichungstag und Bekanntmachung des Hinweises auf die Patenterteilung: **15.08.2018**
(21) Anmeldenummer: 14700144.0
(22) Anmeldetag: 07.01.2014
(51) Int. Cl.: E05B 81/76, H03K 17/955, H03K 17/96

(54) **KAPAZITIVE ANNÄHERUNGSSENSORANORDNUNG AN EINER TÜR EINES KRAFTFAHRZEUGS ZUM ERFASSEN EINER NÄHERUNGSWEISE HORIZONTALEN ANNÄHERUNGSBEWEGUNG EINER BEDIENERHAND**
CAPACITIVE PROXIMITY SENSOR ARRANGEMENT ON A DOOR OF A MOTOR VEHICLE FOR DETECTING AN APPROXIMATELY HORIZONTAL APPROACHING MOVEMENT OF AN OPERATOR'S HAND
ENSEMBLE CAPTEUR DE PROXIMITÉ CAPACITIF SUR UNE PORTE D'UN VÉHICULE AUTOMOBILE POUR DÉTECTER UN MOUVEMENT D'APPROCHE APPROXIMATIVEMENT HORIZONTAL D'UNE MAIN D'OPÉRATEUR

(30) Priorität: 14.01.2013 DE 102013100325
(43) Veröffentlichungstag der Anmeldung: 18.11.2015
(73) Patentinhaber: Huf Hülsbeck & Fürst GmbH & Co. KG, 42551 Velbert (DE)
(72) Erfinder: WITTE, Martin, 48683 Ahaus (DE)
(74) Vertreter: Zenz Patentanwälte Partnerschaft mbB
(86) Internationale Anmeldenummer: PCT/EP2014/050105
(87) Internationale Veröffentlichungsnummer: WO 2014/108377

(56) Entgegenhaltungen:
- EP-A2- 1 505 734
- DE-A1-102008 014 516
- US-A1- 2005 179 672
- US-A1- 2010 019 760

## Beschreibung

Die Erfindung betrifft eine kapazitive Annäherungssensoranordnung an einer Tür eines Kraftfahrzeugs zum Erfassen einer näherungsweise horizontalen Annäherungsbewegung einer Bedienerhand, wobei die Annäherungssensoranordnung in einer Außenwandung benachbart zu einem von der Bedienerhand zu hintergreifenden Griffrand angeordnet ist.

Im Stand der Technik ist es bekannt, kapazitive Annäherungssensoren in der Nähe eines Türgriffs eines Kraftfahrzeugs anzuordnen, um mit diesen die Annäherung einer Hand eines Bedieners zu erfassen. Das Ereignis des Erfassens der Annäherung der Hand des Bedieners löst dann in einer Steuereinrichtung einen Algorithmus zur Abfrage einer Zugriffsberechtigung aus. Die Abfrage der Zugriffsberechtigung umfasst beispielsweise das Aussenden von Abfragesignalen mittels Funkkommunikation, wobei diese Abfragesignale von einem sogenannten elektronischen Schlüssel oder ID-Geber empfangen und mit Antwortsignalen beantwortet werden. Die Auswertung der Antwortsignale und ggf. weiterer im Dialog ausgetauschter Signale führt dann zu einer Überprüfung der Zugriffsberechtigung. Sofern die Zugriffsberechtigung des Bedieners, dessen Hand sich an den kapazitiven Sensor angenähert hat, bejaht wird, führt dies zur Freigabe einer Türschließeinrichtung. Dies wiederum ermöglicht es der dann zugreifenden Hand des Bedieners, die Kraftfahrzeugtür zu öffnen bzw. den Schlossmechanismus zu betätigen.

Die Annäherung der Hand eines Bedieners wird beispielsweise bei einer herkömmlichen Anordnung, welche einen von einer Türwandung abstehenden Türgriff umfasst, durch einen kapazitiven Sensor mit einer Sensorelektrode erfasst, die in dem Türgriff derart angeordnet ist, dass sie ein Eingreifen in den Raum zwischen dem Türgriff und der Türwandung erfasst. Es gibt auch Ausführungsformen, bei denen die Elektrode des kapazitiven Sensors nicht im Türgriff selbst, d.h. im Betätigungselement oder der Handhabe des Türgriffs, angeordnet ist, sondern in einer Griffmulde benachbart zum Betätigungselement des Türgriffs.

Aus der EP 1 505 734 A2 ist ein kapazitiver Annäherungsschalter zur Verwendung in einem Türgriff eines Kraftfahrzeugs bekannt, bei dem mittig zwischen zwei sich in Fahrzeuglängsrichtung erstreckenden, am oberen bzw. unteren Rand des Türgriffs angeordneten Ansprechelektroden eine Kompensationselektrode angeordnet ist. Der offenbarte Annäherungsschalter erfasst eine Geschwindigkeit der Kapazitätsänderung ΔC/Δt, die mit einer oder mehreren Grenzgeschwindigkeiten für eine typische Handbewegung verglichen wird.

Es gibt im Stand der Technik Türöffnungsmechanismen, bei denen ein den Zugang wünschender Bediener mit der Hand in einer im wesentlichen horizontalen Zugriffsbewegung seitlich in eine Griffmulde eingreift und dann eine die Griffmulde teilweise überdeckende Griffplatte, die einen der Griffmulde zugewandten vorderen Außenrand aufweist, hintergreift und die Griffplatte nach außen zieht. Wenn nach dem Hintergreifen der Griffplatte aufgrund der inzwischen bestätigten Zugriffsberechtigung dieses Bedieners ein Schließmechanismus freigegeben worden ist, so kann der Bediener durch Ziehen an der Griffplatte den Schließmechanismus und die Tür öffnen.

Bei einem derartigen Öffnungsmechanismus ist es erwünscht, dass die zum Zugriff auf die Tür führende Handbewegung des Bedieners einerseits möglichst frühzeitig als solche erkannt wird; andererseits soll ein Auslösen des die Zugriffsberechtigung abfragenden Mechanismus durch andere Bewegungen oder Störeinflüsse, die nicht das Hintergreifen der Griffplatte zum Ziel haben, möglichst vermieden werden. Da ein eine Sensorelektrode aufweisender kapazitiven Sensor nicht nur dann Kapazitätsänderungen erfährt, wenn sich eine Bedienerhand an die Sensorelektrode annähert, sondern auch dann, wenn sich andere Körper oder Substanzen, wie beispielsweise Regenwasser, auf die Sensorelektrode bewegen, muss auch vermieden werden, dass derartige Störeinflüsse zum unbeabsichtigten Auslösen des Abfragemechanismus führen.

Der Erfindung liegt daher die Aufgabe zugrunde, eine kapazitive Annäherungssensoranordnung der eingangs genannten Art zu schaffen, die eine Annäherung einer Bedienerhand zum Zwecke des Hintergreifens eines Griffrands frühzeitig und zuverlässig erfasst, aber nur in sehr geringem Maße auf Fehleinflüsse, wie insbesondere Regenwasser, reagiert.

Diese Aufgabe wird erfindungsgemäß durch eine kapazitive Annäherungssensoranordnung mit den Merkmalen des Anspruchs 1 gelöst.

Die erfindungsgemäße kapazitive Annäherungssensoranordnung an einer Tür eines Kraftfahrzeugs zum Erfassen einer näherungsweise horizontalen Annäherungsbewegung einer Bedienerhand ist in einer Außenwandung des Kraftfahrzeugs benachbart zu einem von der Bedienerhand zu hintergreifenden Griffrand angeordnet, beispielsweise in einem Griff-Kunststoffelement, das in die Außenwandung eingelassen ist. Der "Griffrand" kann beispielsweise der Rand der Tür selbst oder ein Außenrand einer eine in der Tür eingelassenen Griffmulde teilweise überdeckenden Griffplatte sein. Unter der zu dem Griffrand "benachbarten" Anordnung ist eine Anordnung in der Nähe des Griffrands zu verstehen, bei der der Abstand zwischen dem Griffrand und den aktiven Sensorelementen so gering ist, dass tatsächlich eine Annäherungsbewegung der Bedienerhand an den Griffrand, d.h. an den Rand der Tür oder den Rand des eine Griffmulde teilweise überdeckenden Griffs, bei der ein Hintergreifen des Griffrands beabsichtigt ist, von einer beliebigen anderen Handbewegung, die kein Hintergreifen des Griffrands zum Ziel hat, unterschieden werden kann. Bei der erfindungsgemäßen kapazitiven Annäherungssensoranordnung sind wenigstens zwei Elektrodenanordnungen vorgesehen, die in der zu erfassenden, näherungsweise horizontalen Bewegungsrichtung beabstandet in einer Fläche (diese braucht nicht eben zu sein) nebeneinander angeordnet sind. Unter einer "näherungsweise" horizontalen Bewegungsrichtung soll auch eine von der Bedienerhand ausgeführte nicht ganz horizontale Richtung einer Bewegung verstanden werden, die ein seitliches Hintergreifen eines Griffrands zum Ziel hat, wobei die Orientierung des Griffrands auch von der vertikalen Richtung abweichen kann, beispielsweise um bis zu 40°. Hierbei besteht jede der Elektrodenanordnungen aus einer sich in einer Querrichtung zu der näherungsweise horizontalen Bewegungsrichtung erstreckenden langgestreckten Elektrode oder aus einer sich in dieser Querrichtung erstreckenden Kette von Elektroden. Unter einer "Querrichtung" soll hier eine vorzugsweise orthogonale oder auch eine davon im spitzen Winkel von weniger als 45° abweichende Richtung verstanden werden. Dabei weist jede Elektrode eine Sensorkapazität gegenüber einem Referenzpotential auf, wobei das Referenzpotential beispielsweise das Erdpotential oder Massepotential ist. Eine Auswerteschaltung ist zum Erfassen von Änderungen der Sensorkapazitäten mit den Elektroden gekoppelt. Dabei sind die Abmessungen und Abstände der Elektroden so gewählt und ist die Auswerteschaltung so konfiguriert, dass sie erfasst, ob sich ein Objekt in näherungsweise horizontaler Richtung mit einer Geschwindigkeit zwischen 0,2 m/s und 2 m/s in unmittelbarer Nähe an den Elektrodenanordnungen vorbeibewegt und an die Tür annähert.

Die erfindungsgemäße kapazitive Annäherungssensoranordnung basiert zunächst auf der Erkenntnis, dass ein Zugriff durch eine Bedienerhand bei stehendem Kraftfahrzeug stattfindet und mit einer im wesentlichen horizontalen Zugriffsbewegung verbunden ist, wohingegen Regenwasser sich im Wesentlichen in vertikaler Richtung bewegt. Darüber hinaus nutzt die erfindungsgemäße Anordnung die Erkenntnis, dass sich die Annäherung der Bedienerhand zum Zwecke des Hintergreifens des Griffrands in einem bestimmten Geschwindigkeitsintervall vollzieht. Die erfindungsgemäße Anordnung gestattet daher eine gute Unterscheidung von gewollter Zugriffsbewegung gegenüber der Hauptstörwirkung des Regenwasserflusses.

Bei der erfindungsgemäßen, beanspruchten Ausführungsform ist die Auswerteschaltung so konfiguriert, dass sie einerseits zumindest einen Wert für einen zeitlichen Versatz eines Anstiegs der Sensorkapazitäten zwischen Elektroden benachbarten Elektrodenanordnungen und andererseits zumindest einen Wert für eine Anstiegsrate der Sensorkapazität zumindest einer Elektrode jeder Elektrodenanordnung bestimmt und ausgehend von diesen Werten entscheidet, ob sich ein Objekt in näherungsweise horizontaler Richtung mit einer Geschwindigkeit zwischen 0,2 m/s und 2 m/s an den Griffrand annähert. Vorzugsweise sind die Elektrodenanordnungen sich quer zu der zu erfassenden Bewegungsrichtung erstreckende Streifenelektroden mit vorgegebener Breite und vorgegebenem Abstand und entscheidet die Auswerteschaltung, dass sich ein Objekt in näherungsweise horizontaler Richtung mit einer Geschwindigkeit zwischen 0,2 m/s und 2 m/s an den Griffrand annähert, sofern erstens der Wert für die Anstiegsrate der Sensorkapazität jeder Streifenelektrode einen Mindestwert überschreitet und zweitens der Kehrwert des zeitlichen Versatzes des Anstiegs der Sensorkapazitäten zwischen den Streifenelektroden multipliziert mit dem Abstand der von dem Griffrand abgewandten Ränder der beiden Streifenelektroden zwischen 0,2 m/s und 2 m/s liegt.

Diese Ausführungsform erlaubt eine noch sicherere Erkennung der den Zugriff wünschenden Bedienerhandbewegung, da nicht nur der zeitliche Versatz sondern auch die Anstiegsrate zumindest einer Sensorelektrodenanordnung ausgewertet wird. Dieser Ausführungsform liegt die Erkenntnis zugrunde, dass eine zu geringe Anstiegsrate trotz eines im relevanten Intervall liegenden zeitlichen Versatzes bei den Kapazitätsänderungen benachbarter Elektrodenanordnungen gegen eine zu erfassende Bedienerhandbewegung spricht. Eine solche zu geringe Anstiegsrate bei einem im richtigen Intervall liegenden Versatz kann beispielsweise durch eine gleichzeitige Anregung zweier benachbarter Elektrodenanordnungen durch zwei unterschiedliche Objekte (beispielsweise Wassertropfen) mit geringem zeitlichen Versatz erzeugt werden.

Bei einer Weiterbildung der Erfindung ist die Auswerteschaltung so konfiguriert, dass sie außerdem zumindest einen Wert für den Verlauf der Sensorkapazität einer Elektrode einer weiter vom Griffrand entfernt angeordneten Elektrodenanordnung bis zum und nach dem Erfassen eines Anstiegs der Sensorkapazität einer Elektrode einer näher am Griffrand angeordneten Elektrodenanordnung bestimmt und auch in Abhängigkeit von diesem Wert entscheidet, ob sich ein Objekt in näherungsweise horizontaler Richtung mit einer Geschwindigkeit zwischen 0,2 m/s und 2 m/s an den Griffrand annähert. Vorzugsweise sind die Elektrodenanordnungen sich quer zu der zu erfassenden Bewegungsrichtung erstreckende Streifenelektroden mit vorgegebener Breite und vorgegebenem Abstand und entscheidet die Auswerteschaltung, dass sich ein Objekt in näherungsweise horizontaler Richtung mit einer Geschwindigkeit zwischen 0,2 m/s und 2 m/s an den Griffrand annähert, sofern erstens der Wert für die Anstiegsrate der Sensorkapazität jeder Streifenelektrode einen Mindestwert überschreitet, zweitens der Kehrwert des zeitlichen Versatzes des Anstiegs der Sensorkapazitäten zwischen den Streifenelektroden multipliziert mit dem Abstand der von dem Griffrand abgewandten Ränder der beiden Streifenelektroden zwischen 0,2 m/s und 2 m/s liegt und drittens der Wert für den Verlauf der Sensorkapazität der weiter vom Griffrand entfernt angeordneten Streifenelektrode bis zum Erfassen des Anstiegs der Sensorkapazität der näher am Griffrand angeordneten Streifenelektrode keinen wesentlichen Abfall der Sensorkapazität anzeigt.

Bei dieser bevorzugten Ausführungsform wird zusätzlich der Verlauf der Sensorkapazität der zeitlich früher ausgelösten Streifenelektrode bis zum und nach dem Auslösen der weiter am Griffrand angeordneten, später ausgelösten Sensorelektrode überwacht. Bei der zugreifenden Hand handelt es sich nämlich um ein relativ großes Objekt, so dass eine erhöhte Sensorkapazität der früher ausgelösten Elektrode auch dann noch vorhanden sein muss, wenn nachfolgend eine weiter zum Griffrand liegende Elektrodenanordnung angeregt wird. Sofern dies nicht der Fall ist, ist das sich an den Griffrand annähernde Objekt zu klein, um als Hand zu gelten.

Bei einem Ausführungsbeispiel sind die Elektrodenanordnungen sich quer zu der zu erfassenden Bewegungsrichtung erstreckende Streifenelektroden mit vorgegebener Breite und vorgegebenem Abstand. Hierbei ist bevorzugt, dass die kapazitive Annäherungssensoranordnung wenigstens drei näherungsweise parallele Streifenelektroden aufweist, wobei die Auswerteschaltung unter anderem den zeitlichen Versatz und die zeitliche Reihenfolge der Anstiege der Sensorkapazitäten der wenigstens drei Streifenelektroden auswertet.

Diese bevorzugte Ausführungsform stellt ein Optimum zwischen einer für eine gute Erfassung ausreichenden Anzahl von Elektroden und geringen Kosten durch geringen baulichen Aufwand dar.

Bei einer bevorzugten Weiterbildung ist über den oberen Enden der Streifenelektroden und beabstandet zu diesen eine weitere Streifenelektrode vorgesehen, die sich in näherungsweise horizontaler Richtung erstreckt und ebenfalls mit der Auswerteschaltung gekoppelt ist, wobei die Auswerteschaltung so konfiguriert ist, dass sie zusätzlich in Abhängigkeit von wenigstens einem den Verlauf der Sensorkapazität der weiteren Streifenelektrode kennzeichnenden Wert entscheidet, ob sich ein Objekt in näherungsweise horizontaler Richtung an den Griffrand annähert. Vorzugsweise ist die Auswerteschaltung so konfiguriert, dass sie entscheidet, dass sich das Objekt nicht in näherungsweise horizontaler Richtung an den Griffrand annähert, wenn unmittelbar vor einem Anstieg einer der Sensorkapazitäten der sich quer zu der zu erfassenden Bewegungsrichtung erstreckende Streifenelektroden ein Anstieg der Sensorkapazität der sich in näherungsweise horizontaler Richtung erstreckenden weiteren Streifenelektrode erfasst wurde, der einen vorgegebenen Schwellwert überschreitet.

Vorteilhaft ist die zusätzliche Anordnung einer horizontalen (oder im Wesentlichen horizontalen) Streifenelektrode oberhalb der im Wesentlichen senkrechten Streifenelektroden, weil diese horizontale Streifenelektrode eine frühzeitige Erfassung herabfließender Wassertropfen oder Wasserbahnen gestattet. Das Auslösen der horizontalen Elektrode vor einem Auslösen einer der vertikalen Elektroden kann beispielsweise von der Auswerteschaltung verwendet werden, um ein zeitliches Sperrintervall zu starten, in dem Auslösungen der vertikalen Streifenelektroden ignoriert werden. Insgesamt gestattet diese Weiterbildung eine noch genauere Unterscheidung des Erfassens der gewollten Bewegung von den anderen möglichen Auslösemechanismen.

Bei bevorzugten Ausführungsformen weist die Auswerteschaltung einen Mikrocontroller und Schaltungen auf, die die Elektroden ansteuern und in vorgegebenen Zeitintervallen Werte bestimmen, die ein Maß für die Sensorkapazität oder deren Änderung darstellen, wobei der Mikrocontroller diese Werte verarbeitet, um ein die Entscheidung darüber, ob sich ein Objekt in näherungsweise horizontaler Richtung mit einer Geschwindigkeit zwischen 0,2 m/s und 2 m/s in unmittelbarer Nähe an den Elektrodenanordnungen vorbeibewegt und an den Griffrand annähert, kennzeichnendes Ausgabesignal zu erzeugen.

Vorteilhafte und/oder bevorzugte Weiterbildungen und Ausführungsformen der Erfindung sind in den Unteransprüchen gekennzeichnet.

Nachfolgend wird die Erfindung anhand von in den Zeichnungen dargestellten bevorzugten Ausführungsbeispielen näher beschrieben. In den Zeichnungen zeigen:
Figur 1 eine schematische Darstellung eines Ausschnitts einer Kraftfahrzeugtür mit angrenzender Karosserie, die eine erste Ausführungsform der erfindungsgemäßen Annäherungssensoranordnung zeigt, bei der die Sensoranordnung in einer in der Kraftfahrzeugtür eingelassenen Griffmulde untergebracht ist;
Figur 2 eine schematische Darstellung eines Ausschnitts des Randes der Kraftfahrzeugtür mit angrenzender Karosserie, die eine zweite Ausführungsform der Erfindung veranschaulicht, bei der die kapazitive Annäherungssensoranordnung in einer Griffmulde untergebracht ist, die benachbart zum Rand der Kraftfahrzeugtür angeordnet ist;
Figur 3 eine schematische Darstellung einer ersten Ausführungsform der Anordnung der Sensorelektroden und deren Kopplung mit der Auswerteschaltung;
Figur 4 eine schematische Darstellung einer zweiten Ausführungsform der Anordnung der Sensorelektroden; und
Figur 5 eine schematische Darstellung beispielhafter Signalverläufe von Signalen, die den Kapazitäten der gemäß Figur 3 angeordneten Sensorelektroden entsprechen.

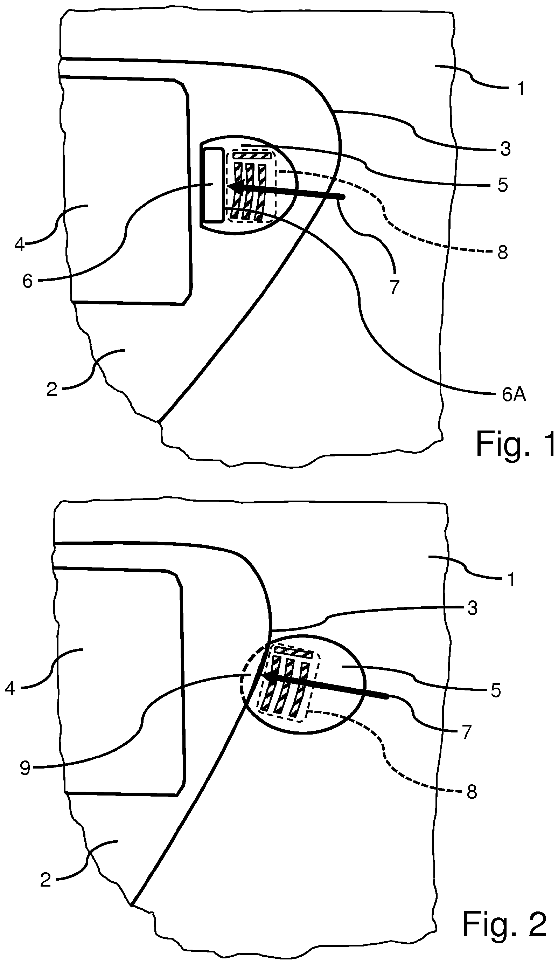

Die Figuren 1 und 2 veranschaulichen zwei Ausführungsformen für die Anordnung der erfindungsgemäßen kapazitiven Annäherungssensoranordnung an einer Tür eines Kraftfahrzeugs. Bei der Ausführungsform gemäß Figur 1 weist die Kraftfahrzeugtür eine Griffmulde auf, die zum Teil von einer zu hintergreifenden Griffplatte überdeckt wird, wobei ein Nach-Außen-Ziehen der Griffplatte einen Türöffnungsmechanismus betätigt. Die erfindungsgemäße Annäherungssensoranordnung ist dann in der Griffmulde untergebracht. Bei der Ausführungsform gemäß Figur 2 ist die Griffmulde benachbart und zum Teil unter einem Rand der Tür angeordnet, so dass in der Griffmulde der Rand der Tür hintergriffen werden kann. Hier ist die erfindungsgemäße Annäherungssensoranordnung ebenfalls in der Griffmulde benachbart zum Rand der Tür angeordnet.

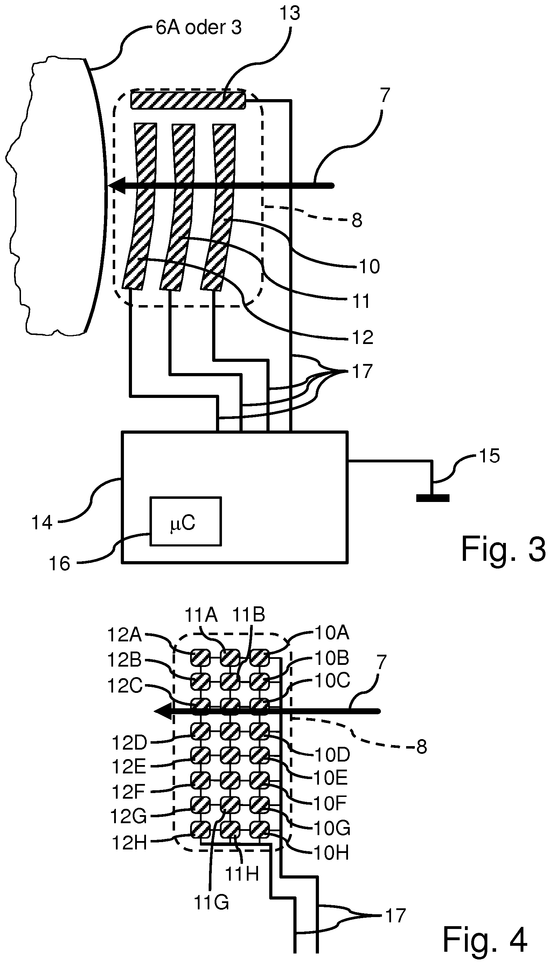

Figur 1 zeigt schematisch einen Ausschnitt 1 der Kraftfahrzeugkarosserie mit einem Abschnitt einer Tür 2. Die Tür 2 weist eine Fensteröffnung 4 auf. Ein Außenrand 3 begrenzt die Tür 2. In der Tür 2 ist neben dem Fenster 4 eine Griffmulde 5 eingelassen, wobei die Griffmulde 5 teilweise von einer Griffplatte 6 überdeckt wird. Die Griffplatte 6 kann von der Hand eines Bedieners in der Griffmulde 5 hintergriffen werden. Wenn der Bediener mit seiner Hand die Griffplatte 6 nach außen zieht, so wird ein Türöffnungsmechanismus betätigt. Beispielsweise kann die Griffplatte 6 geringfügig nach außen geschwenkt werden. In der Bodenfläche der Griffmulde 5 ist eine kapazitive Annäherungssensoranordnung 8 untergebracht. Die kapazitive Annäherungssensoranordnung 8 weist mehrere flächige Metallelektroden auf, deren Ausbildung und Anordnung in den Ausführungsbeispielen gemäß Figur 3 und Figur 4 näher dargestellt ist.

Figur 2 zeigt ebenfalls einen Ausschnitt 1 einer Kraftfahrzeugkarosserie mit einem Türabschnitt 2, der ein Fenster 4 aufweist. Die Tür 2 wird durch einen Außenrand 3 begrenzt. Benachbart zu dem Außenrand 3 ist eine Griffmulde 5 in die Karosserieaußenfläche eingelassen. Derjenige Teil der Griffmulde 5, der sich hinter einem Abschnitt der Tür 2 befindet, ist mit dem Bezugszeichen 9 gekennzeichnet.

In den Figuren 1 und 2 ist die bevorzugte Bewegungsrichtung beim Eingreifen der Hand des Bedieners durch den Pfeil 7 dargestellt. Die Richtung des Pfeils 7 erstreckt sich näherungsweise in horizontaler Richtung. Bei der Ausführungsform gemäß Figur 1 hintergreift die Bedienerhand, wenn sie sich in Richtung des Pfeils 7 bewegt, schließlich einen Außenrand 6A der Griffplatte 6. Bei der Ausführungsform gemäß Figur 2 hintergreift die Bedienerhand, wenn sie sich entlang des Pfeils 7 bewegt, schließlich den Rand 3 der Tür 2.

Mit den in den Figuren 1 und 2 dargestellten Annäherungssensoranordnungen 8 soll die Bewegung der Bedienerhand entlang der Richtung des Pfeils 7 erfasst werden, bevor die Hand den Rand 6A der Griffplatte 6 bzw. den Rand 3 der Tür 2 hintergreift, so dass nach dem Erfassen der Bewegung der Bedienerhand von einer Steuereinrichtung des Kraftfahrzeugs ein der Abfrage der Zugriffsberechtigung dienender Funkdialog zwischen der Steuereinrichtung des Kraftfahrzeugs und einem sogenannten elektronischen Schlüssel oder ID-Geber, der sich beim Bediener befindet, ausgelöst werden kann. Dieser Funkdialog und dessen Auswertung müssen abgeschlossen sein, bevor die Hand des Bedieners die hintergriffene Griffplatte 6 bzw. die hintergriffene Tür 2 nach außen ziehen kann, damit zuvor der Schließmechanismus ausgelöst werden kann.

Figur 3 zeigt schematisch eine erste Ausführungsform der Anordnung der Elektroden des kapazitiven Annäherungssensors innerhalb der Annäherungssensoranordnung 8, die benachbart zu einem Rand 6A der Griffplatte 6 bzw. einem Rand 3 der Tür 2 angeordnet sein kann. Bei dem in Figur 3 dargestellten Ausführungsbeispiel der Annäherungssensoranordnung 8 sind vier in der Bodenfläche der Griffmulde angeordnete flächige Metallelektroden 10, 11, 12 und 13 vorgesehen. Drei Elektroden 10, 11 und 12 sind sich im Wesentlichen vertikal erstreckende Streifenelektroden vorgegebener Breite und vorgegebenen Abstands. Die Streifenelektroden 10, 11 und 12 erstrecken sich im Wesentlichen rechtwinkelig oder quer zu der bevorzugt erwarteten Bewegung der Bedienerhand entlang des Pfeils 7. Die Streifenelektrode 10 ist von dem zu hintergreifenden Rand (6A oder 3) am weitesten entfernt angeordnet, so dass sich die Bedienerhand bei der gewünschten Bewegung entlang des Pfeils 7 zuerst der Streifenelektrode 10 annähert. Die weiteren Streifenelektroden 11 und 12 sind dann entsprechend näher am zu hintergreifenden Rand angeordnet, so dass sich die Bedienerhand bei der Bewegung entlang des Pfeils 7 zunächst an die Elektrode 10, dann an die Elektrode 11 und schließlich an die Elektrode 12 annähert. Eine zusätzliche Elektrode 13 ist in näherungsweise horizontaler Richtung oberhalb der oberen Enden der Streifenelektroden 10, 11 und 12 angeordnet. Sämtliche Elektroden 10, 11, 12 und 13 der kapazitiven Annäherungssensoranordnung 8 sind über Verbindungsleitungen 17 mit einer Auswerteschaltung 14 gekoppelt. Die Auswerteschaltung 14 dient zum Erfassen der Kapazitäten der Sensorelektroden 10, 11, 12 und 13 gegenüber einem Referenzpotential, insbesondere gegenüber Massepotential. Die Auswerteschaltung 14 ist zu diesem Zweck außerdem mit einem Masseanschluss 15 verbunden. Die Auswerteschaltung 14 enthält neben einem die Erfassung und Auswertung steuernden Mikrocontroller auch Messschaltungen, die die jeweiligen Kapazitäten der Elektroden 10, 11, 12 und 13 gegenüber dem Referenzpotential 15 erfassen und dem Mikrocontroller als Werte zur Verfügung stellen. Die Sensorelektroden 10, 11, 12 sind so angeordnet und die Auswerteschaltung ist so konfiguriert, dass der Mikrocontroller programmgesteuert bei entsprechenden Änderungen der Sensorkapazitäten erfassen kann, ob sich ein Objekt in näherungsweise horizontaler Richtung, also entlang des Pfeils 7, bewegt und ob sich dieses Objekt mit einer Geschwindigkeit zwischen etwa 0,2 m/s und 2 m/s bewegt. Die vertikale Ausrichtung der Streifenelektroden 10, 11 und 12, die horizontale Ausrichtung der zusätzlichen Elektrode 13 und die Auswertung der Kapazitätsänderungen durch die Auswerteschaltung 14 erlauben eine gute Unterscheidung einer Kapazitätsänderung aufgrund der zu erfassenden Bewegung einer Bedienerhand entlang des Pfeils 7 von Kapazitätsänderungen, die von anderen Bewegungen von Objekten oder von Störeinflüssen ausgehen.

Figur 4 zeigt ein Beispiel einer alternativen Ausführungsform für die Anordnung von Sensorelektroden in der Fläche der kapazitiven Annäherungssensoranordnung 8. Die zu erfassende bevorzugte Bewegungsrichtung der Bedienerhand ist wiederum durch den Pfeil 7 dargestellt. Wie man in Figur 4 erkennen kann, umfasst die kapazitive Annäherungssensoranordnung 8 eine Vielzahl kleiner Elektroden, wobei jeweils eine Gruppe von Elektroden in vertikaler Richtung übereinander angeordnet ist. Die vertikal übereinander angeordneten Elektroden 10A bis 10H bilden eine erste Elektrodenanordnung, die Elektroden 11A bis 11H eine zweite Elektrodenanordnung und die Elektroden 12A bis 12H eine dritte Elektrodenanordnung. Die Elektrodenanordnungen aus vertikal übereinander angeordneten Elektroden sind horizontal in vorgegebenem Abstand nebeneinander angeordnet. Jede der Elektroden ist über jeweils eine Zuleitung 17 mit der (in Figur 4 nicht dargestellten) Auswerteschaltung 14 verbunden. Die eine Vielzahl von Elektroden aufweisende Sensoranordnung gemäß Figur 4 erlaubt eine gute Erfassung von Bewegungsrichtung von Objekten, die sich über die Fläche der Annäherungssensoranordnung 8 hinwegbewegen. Funktionell ist eine solche Sensoranordnung einem Touchscreen ähnlich.

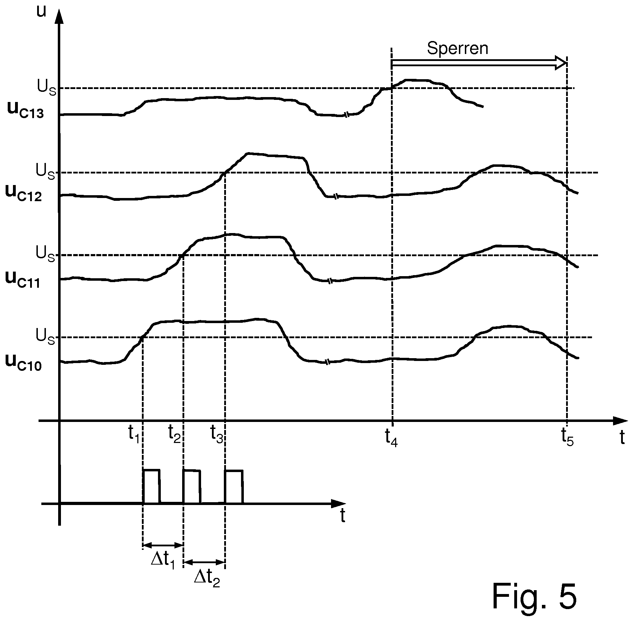

Figur 5 veranschaulicht die Funktion der in Figur 3 dargestellten kapazitiven Annäherungssensoranordnung anhand von beispielhaften Signalverläufen. Bei der Ausführungsform gemäß Figur 5 sei angenommen, dass innerhalb der Auswerteschaltung Spannungen erzeugt werden, die ein Maß für die jeweilige Kapazität einer Sensorelektrode 10, 11 und 12 oder 13 gegenüber dem Referenzpotential Masse darstellen. Diese die Sensorkapazität wiedergebenden Signalspannungen sind als u_{C10} - u_{C13} dargestellt. Bei der Annäherung eines Objekts, wie beispielsweise einer Bedienerhand, an die Oberfläche einer Sensorelektrode erhöht sich die Sensorkapazität gegenüber Masse, was durch eine entsprechende Erhöhung der Signalspannung u_{C} dargestellt ist. Die vertikale Achse des in Figur 5 dargestellten Diagramms kennzeichnet die Signalspannung, die horizontale Achse den Zeitablauf. In einem ersten Zeitabschnitt sind beispielhafte Signalverläufe für den Fall der Bewegung einer Bedienerhand entlang des Pfeils 7 bei der Ausführungsform gemäß Figur 3 dargestellt. Nähert sich die Bedienerhand entlang des Pfeils 7 der Sensorelektrode 10 an, so steigt die Signalspannung u_{C10} an. Dies ist im unteren Signalverlauf in Figur 5 dargestellt. Zum Zeitpunkt t₁ überschreitet die ansteigende Signalspannung u_{C10} einen Schwellwert, d.h. eine Schwellspannung U_{S}. Die Schwellspannung U_{S} ist durch eine gestrichelte Linie dargestellt. Die Bedienerhand bewegt sich dann weiter in Richtung des Pfeils 7 (vergleiche Figur 3), woraufhin sie sich zunächst der Sensorelektrode 11 und dann der Sensorelektrode 12 annähert. Die sich daraus ergebenden Erhöhungen der Signalspannungen u_{C11} und u_{C12} sind ebenfalls in Figur 5 dargestellt. Zum Zeitpunkt t₂ überschreitet die Signalspannung u_{C11} den Schwellwert U_{S}, und zum Zeitpunkt t₃ überschreitet die Signalspannung u_{C12} die Schwellspannung U_{S}. Aufgrund der Bewegungsrichtung der Hand überschreitet die Signalspannung u_{C11} den Schwellwert U_{S} nach dem Zeitpunkt, zu dem die Signalspannung u_{C10} den Schwellwert U_{S} überschreitet. Die zeitliche Differenz zwischen den Zeitpunkten t₁ und t₂ ist durch den Abstand Δt₁ veranschaulicht. Figur 5 stellt im untersten Signalverlauf drei Rechteckimpulse dar. Dies soll veranschaulichen, dass in dem Mikrocontroller 16 der Auswerteschaltung 14 jeweils ein digitaler Impuls erzeugt wird, wenn eine der Signalspannungen u_{C} einen Schwellwert U_{S} überschreitet. Der Zeitpunkt ist durch eine ansteigende Flanke der binären Impulse repräsentiert. Die Abstände zwischen den ansteigenden Flanken zu den Zeitpunkten t₁ bis t₃ sind durch die Zeitdifferenzen Δt₁ und Δt₂ veranschaulicht. Die Auswerteschaltung 14 ermittelt sowohl die Zeitpunkte t₁ bis t₃ als auch die Zeitdifferenzen Δt₁ und Δt₂. Darüber hinaus kann die Auswerteschaltung auch noch ein Maß für den Anstieg der Signalspannung u_{C} zum Zeitpunkt des Überschreitens des Schwellwerts U_{S} oder zu einem weiteren Zeitpunkt ermitteln. Aus den ermittelten Zeitpunkten, Zeitdifferenzen und Anstiegen bestimmt die Auswerteschaltung 14 mit Hilfe des programmgesteuerten Mikrocontrollers 16, ob sich ein Objekt mit einer Geschwindigkeit im Zeitintervall zwischen 0,2 m/s und 2 m/s entlang der Richtung des Pfeils 7 in der Nähe der Sensorelektroden 10, 11 und 12 bewegt hat. Sofern dies der Fall ist, erzeugt der Mikrocontroller ein Signal, dass die zu erfassende Bewegung der Bedienerhand anzeigt und zum Auslösen der Berechtigungsabfragedialoge führt.

In der obersten Zeile der Signalverläufe gemäß Figur 5 ist der Signalverlauf der Signalspannung u_{C13} veranschaulicht, der die Kapazitätsänderung der im Wesentlichen horizontal angeordneten Elektrode 13 veranschaulicht. Bewegt sich die Bedienerhand, wie oben dargestellt, entlang des Pfeils 7 (vergleiche Figur 3), so erhöht sich auch die Kapazität der Elektrode 13. Bei dem in Figur 5 dargestellten Ausführungsbeispiel ist die Erhöhung jedoch nicht so groß, dass sie den Schwellwert U_{S} überschreitet. In einem rechts sich anschließenden, späteren Signalverlauf ist dagegen dargestellt, dass die Signalspannung u_{C13} zu einem Zeitpunkt t₄ den Schwellwert U_{S} überschreitet. Wenn dieser Fall eintritt, während zugleich die Signalspannungen der drei vertikalen Elektroden u_{C10} bis u_{C12} unterhalb ihrer Schwellwerte U_{S} verbleiben, so nimmt die Auswerteschaltung an, dass eine vertikale Bewegung eines Objekts von oben nach unten stattfindet, wobei das Objekt zunächst die obere Elektrode 13 erreicht hat. Ein derartiges Objekt kann beispielsweise Regenwasser in Form von vertikal herabfließenden Tropfen oder Wasserbahnen sein. In Figur 5 ist dann weiterhin der Fall dargestellt, dass das Regenwasser mit zeitlichem Versatz die vertikalen Elektroden 10 bis 12 erreicht, so dass auch deren Kapazitäten ansteigen. Dieser Anstieg erfolgt hier etwa zeitgleich, wobei hier angenommen werden soll, dass das Regenwasser großflächig von oben nach unten fließt und kurze Zeit nach dem Erreichen der Elektrode 13 etwa zeitgleich die Elektroden 10 bis 12 erreicht. Die Auswerteschaltung 14 mit dem Controller 16 ist so konfiguriert, dass sie nach dem Ereignis zum Zeitpunkt t₄ die weitere Auswertung der Kapazitätsänderungen der Elektroden 10 bis 12 für einen vorgegebenen Zeitraum, hier bis zum Zeitpunkt t₅, sperrt. Während dieser Sperrzeit werden die Kapazitätsänderungen der Elektroden 10 bis 12 nicht ausgewertet. Diese Vorgehensweise vermeidet ein Fehlauslösen der Berechtigungsabfrage durch einen eine Objektannäherung vortäuschenden Fluss von Wasser.

Die in Figur 5 dargestellten Signalverläufe sind hier nur beispielhaft. Darüber hinaus ist eine Reihe von Algorithmen vorstellbar, die von denen abweichen, die anhand der Signalverläufe der Figur 5 beschrieben wurden. Beispielsweise ist es denkbar, dass zum Auslösen eines Sperrsignals (für eine vorgegebene Zeitdauer) eine Reihe bestimmter Ereignisabfolgen, d. h. von Folgen von Kapazitätsänderungen an den Sensoren 10 bis 13, führen.

## Patentansprüche

1. Kapazitive Annäherungssensoranordnung (8) an einer Tür (2) eines Kraftfahrzeugs zum Erfassen einer näherungsweise horizontalen Annäherungsbewegung einer Bedienerhand, wobei die Annäherungssensoranordnung (8) in einer Außenwandung benachbart zu einem von der Bedienerhand zu hintergreifenden Griffrand (6A; 3) angeordnet ist,
wobei wenigstens zwei Elektrodenanordnungen vorgesehen sind, die in der zu erfassenden, näherungsweise horizontalen Bewegungsrichtung (7) der Annäherungsbewegung beabstandet in einer Fläche nebeneinander angeordnet sind, wobei jede der Elektrodenanordnungen aus einer sich in einer Querrichtung zu der näherungsweise horizontalen Bewegungsrichtung erstreckenden langgestreckten Elektrode (10, 11, 12) oder aus einer sich in dieser Querrichtung erstreckenden Kette von Elektroden (10A-H, 11A-H, 12A-H) besteht, wobei jede Elektrode (10, 11, 12; 10A-H, 11A-H, 12A-H) eine Sensorkapazität gegenüber einem Referenzpotential (15) aufweist, und
wobei eine Auswerteschaltung (14) zum Erfassen von Änderungen der Sensorkapazitäten mit den Elektroden gekoppelt ist, wobei die Abmessungen und Abstände der Elektroden so gewählt sind und die Auswerteschaltung (14) so konfiguriert ist, dass sie erfasst, ob sich ein Objekt in näherungsweise horizontaler Richtung mit einer Geschwindigkeit zwischen 0,2 m/s und 2 m/s in unmittelbarer Nähe an den Elektrodenanordnungen vorbeibewegt und an den Griffrand (6A; 3) annähert, indem die Auswerteschaltung einerseits zumindest einen Wert für einen zeitlichen Versatz (Δt₁, Δt₂) eines Anstiegs der Sensorkapazitäten zwischen Elektroden (10, 11, 12; 10A-H, 11A-H, 12A-H) benachbarter Elektrodenanordnungen und andererseits zumindest einen Wert für eine Anstiegsrate der Sensorkapazität zumindest einer Elektrode jeder Elektrodenanordnung bestimmt und ausgehend von diesen Werten eine näherungsweise horizontale Annäherungsbewegung einer Bedienerhand erfasst, sofern
erstens der Wert für die Anstiegsrate der Sensorkapazität zumindest einer Elektrode jeder Elektrodenanordnung einen Mindestwert überschreitet und
zweitens der Kehrwert des zeitlichen Versatzes (Δt₁, Δt₂) des Anstiegs der Sensorkapazitäten zwischen den Elektroden (10, 11, 12; 10A-H, 11A-H, 12A-H) der benachbarten Elektrodenanordnungen (10, 11, 12) multipliziert mit dem Abstand der von dem Griffrand (6A; 3) abgewandten Ränder der Elektroden (10, 11, 12; 10A-H, 11A-H, 12A-H) der benachbarten Elektrodenanordnungen (10, 11, 12) zwischen 0,2 m/s und 2 m/s liegt.

2. Kapazitive Annäherungssensoranordnung nach Anspruch 1, **dadurch gekennzeichnet, dass** die Elektrodenanordnungen Streifenelektroden (10, 11, 12) mit vorgegebener Breite und vorgegebenem Abstand sind.

3. Kapazitive Annäherungssensoranordnung nach Anspruch 1 oder 2, **dadurch gekennzeichnet, dass** die Auswerteschaltung (14) so konfiguriert ist, dass sie außerdem zumindest einen Wert für den Verlauf der Sensorkapazität einer Elektrode einer weiter vom Griffrand (6A; 3) entfernt angeordneten Elektrodenanordnung bis zum und nach dem Erfassen eines Anstiegs der Sensorkapazität einer Elektrode einer näher am Griffrand (6A; 3) angeordneten Elektrodenanordnung bestimmt und auch in Abhängigkeit von diesem Wert entscheidet, ob sich ein Objekt in näherungsweise horizontaler Richtung mit einer Geschwindigkeit zwischen 0,2 m/s und 2 m/s an den Griffrand annähert.

4. Kapazitive Annäherungssensoranordnung nach Anspruch 3, **dadurch gekennzeichnet, dass** die Elektrodenanordnungen Streifenelektroden (10, 11, 12) mit vorgegebener Breite und vorgegebenem Abstand sind und die Auswerteschaltung (14) entscheidet, dass sich ein Objekt in näherungsweise horizontaler Richtung mit einer Geschwindigkeit zwischen 0,2 m/s und 2 m/s an den Griffrand annähert, sofern außerdem - drittens - der Wert für den Verlauf der Sensorkapazität der weiter vom Griffrand (6A; 3) entfernt angeordneten Streifenelektrode bis zum Erfassen des Anstiegs der Sensorkapazität der näher am Griffrand angeordneten Streifenelektrode keinen wesentlichen Abfall der Sensorkapazität anzeigt.

5. Kapazitive Annäherungssensoranordnung nach einem der Ansprüche 2-4 **dadurch gekennzeichnet, dass** wenigstens drei näherungsweise parallele Streifenelektroden (10, 11, 12) vorgesehen sind, wobei die Auswerteschaltung (14) unter anderem den zeitlichen Versatz und die zeitliche Reihenfolge der Anstiege der Sensorkapazitäten der drei Streifenelektroden auswertet.

6. Kapazitive Annäherungssensoranordnung nach Anspruch 5, **dadurch gekennzeichnet, dass** über den oberen Enden der Streifenelektroden (10, 11, 12) und beabstandet zu diesen eine weitere Streifenelektrode (13) vorgesehen ist, die sich in näherungsweise horizontaler Richtung erstreckt und ebenfalls mit der Auswerteschaltung (14) gekoppelt ist, wobei die Auswerteschaltung (14) so konfiguriert ist, dass sie zusätzlich in Abhängigkeit von wenigstens einem den Verlauf der Sensorkapazität der weiteren Streifenelektrode (13) kennzeichnenden Wert entscheidet, ob sich ein Objekt in näherungsweise horizontaler Richtung an den Griffrand (6A; 3) annähert.

7. Kapazitive Annäherungssensoranordnung nach Anspruch 6, **dadurch gekennzeichnet, dass** die Auswerteschaltung (14) so konfiguriert ist, dass sie entscheidet, dass sich das Objekt nicht in näherungsweise horizontaler Richtung an den Griffrand annähert, wenn unmittelbar vor einem Anstieg einer der Sensorkapazitäten der sich quer zu der zu erfassenden Bewegungsrichtung erstreckende Streifenelektroden (10, 11, 12) ein Anstieg der Sensorkapazität der sich in näherungsweise horizontaler Richtung erstreckenden weiteren Streifenelektrode (13) erfasst wurde, der einen vorgegebenen Schwellwert überschreitet.

8. Kapazitive Annäherungssensoranordnung nach einem der Ansprüche 1 - 7, **dadurch gekennzeichnet, dass** die Auswerteschaltung (14) einen Mikrocontroller (16) und Schaltungen aufweist, die die Elektroden ansteuern und in vorgegebenen Zeitintervallen Werte bestimmen, die ein Maß für die Sensorkapazität oder deren Änderung darstellen, wobei der Mikrocontroller (16) diese Werte verarbeitet, um ein die Entscheidung darüber, ob sich ein Objekt in näherungsweise horizontaler Richtung mit einer Geschwindigkeit zwischen 0,2 m/s und 2 m/s in unmittelbarer Nähe an den Elektrodenanordnungen vorbeibewegt und an den Griffrand (6A; 3) annähert, kennzeichnendes Ausgabesignal zu erzeugen.

## Claims

1. Capacitive proximity sensor arrangement (8) on a door (2) of a motor vehicle for detecting an approximately horizontal approaching movement of an operator's hand, wherein the proximity sensor arrangement (8) is arranged in an outer wall adjacent to a grip edge (6A; 3) to be gripped from behind by the operator's hand, wherein at least two electrode arrangements are provided which are arranged next to each other in one place in the approximately horizontal direction of movement (7) of the approaching movement, wherein each of the electrode arrangements consists of an elongated electrode (10, 11, 12) extending in a direction perpendicular to the approximately horizontal direction of movement, or of a chain of electrodes (10 A-H, 11 A-H, 12 A-AH) extending in this perpendicular direction, wherein each electrode (10, 11, 12; 10 A-H, 11 A-H, 12, A-H) has a sensor capacity with regard to a reference potential, and
wherein an evaluation circuit (14) for detecting changes of the sensor capacities is connected to the electrodes, wherein the dimensions and spacing of the electrodes are selected and the evaluation circuit (14) is configured in such a way that it detects whether an object is moving past the electrode arrangements in the immediate vicinity in a horizontal direction at a speed of between 0.2 m/s and 2 m/s and approaching the grip edge (6A; 3), in that evaluation circuit on the one hand determines at least one value for the time offset (Δt₁, Δt₂) of an increase in sensor capacity between electrodes (10, 11, 12; 10 AH, 11 A-H, 12, A-H) of adjacent electrode arrangements, and on the other hand determines at least one value for a rate of increase in the sensor capacity of at least one electrode of each electrode arrangement and on the basis of the values detects an approximately horizontal approaching movement of an operator's hand, if
firstly, the value for the rate of increase in the sensor capacity of at least one electrode of each electrode arrangement exceeds a minimum value and secondly the reciprocal value of the time offset (Δt₁, Δt₂) of the increase in sensor capacities between the electrodes (10, 11, 12; 10 A-H, 11 A-H, 12, A-H) of the adjacent electrode arrangements (10, 11, 12) multiplied by the spacing of the edges of the electrodes (10, 11, 12; 10 A-H, 11 A-H, 12, A-H) of the adjacent electrode arrangements (10, 11, 12) facing away from the grip edge (6A; 3) is between 0.2 m/s and 2 m/s.

2. Capacitive proximity sensor arrangement according to claim 1 **characterised in that** the electrode arrangements are strip electrodes (10, 11, 12) of predetermined width and with predetermined spacing.

3. Capacitive proximity sensor arrangement according to claim 1 or 2 **characterised in that** the evaluation circuit (14) is configured in such a way that it also determines at least one value for the course of the sensor capacity of an electrode of an electrode arrangement arranged further from the grip edge (6A; 3) up to and after recording an increase in the sensor capacity of an electrode of an electrode arrangement arranged closer to the grip edge (6A; 3), and as a function of this value also decides whether an object is approaching the grip edge in an approximately horizontal direction at a speed of between 0.2 m/s and 2 m/s.

4. Capacitive proximity sensor arrangement according to claim 3 **characterised in that** the electrode arrangements are strip electrodes (10, 11, 12) of predetermined width and with predetermined spacing and the evaluation circuit (14) decides that an object is approaching the grip edge in an approximately horizontal direction at a speed of between 0.2 m/s and 2 m/s, if
also - thirdly -
the value for the course of the sensor capacity of the strip electrode arranged further from the grip edge (6A; 3) does not exhibit an essential decrease in sensor capacity before detecting the increase in the sensor capacity of the strip electrode arranged closed to the grip edge.

5. Capacitive proximity sensor arrangement according any one of claims 2-4, **characterised in that** at least three approximately parallel strip electrodes (10, 11, 12) are provided, wherein, amongst other things, the evaluation circuit (14) evaluates the time offset and time sequence of the increase in the sensor capacities of the three strip electrodes.

6. Capacitive proximity sensor arrangement according to claim 5 **characterised in that** above the upper ends of the strip electrode (10, 11, 12) and at a distance therefrom a further strip electrode (12) is provided which extends in an approximately horizontal direction and is also connected to the evaluation circuit (14), wherein the evaluation circuit (14) is configured in such a way that it also as a function of at least one value characterising the course of the sensor capacity of the further strip electrode (13) decides whether an object is approaching the grip edge in an approximately horizontal direction (6A; 3).

7. Capacitive proximity sensor arrangement according to claim 6 **characterised in that** the evaluation circuit (14) is configured in such a way that it decides that the object is not approaching the grip edge in an approximately horizontal direction if immediately before an increase in one of the sensor capacities of the strip electrodes (10, 11, 12) extending perpendicularly to the direction of movement to be detected an increase in the sensor capacity of the further strip electrode extending in an approximately horizontal direction (13) has been detected that exceeds a predetermined threshold value.

8. Capacitive proximity sensor arrangement according to any one of claims 1 to 7 **characterised in that** the evaluation circuit (14) comprises a microcontroller (16) and circuits which control the electrodes and at predetermined intervals determine values which represent a measure of the sensor capacity or its changes, wherein the microcontroller (16) processes these values in order to generate an output signal characterising the decision on whether an object is moving past the immediate vicinity of the electrode arrangement in an approximately horizontal direction at a speed of between 0.2 m/s and 2 m/is and is approaching the grip edge (6A; 3).

## Revendications

1. Agencement capacitif de capteurs de proximité (8) sur une portière (2) d'un véhicule automobile, destiné à détecter un déplacement d'approche approximativement horizontal de la main d'un utilisateur, l'agencement de capteurs de proximité (8) étant placé dans une paroi extérieure, au voisinage d'un bord de poignée (6A ; 3) qui doit être empoigné par l'arrière par la main de l'utilisateur,
au moins deux agencements d'électrodes étant prévus, qui dans la direction de déplacement (7) approximativement horizontale qui doit être détectée sont placées côte à côte avec un écart dans une surface, chacun des agencements d'électrodes consistant dans une électrode (10, 11, 12) allongée, s'étendant dans une direction transversale à la direction de déplacement approximativement horizontale ou dans une chaîne d'électrodes (10A-H, 11A-H, 12A-H) s'étendant dans ladite direction transversale, chaque électrode (10, 11, 12 ; 10A-H, 11A-H, 12A-H) disposant d'une capacité de capteur par rapport à un potentiel de référence (15) et
un circuit d'évaluation (14) destiné à détecter des modifications des capacités de capteurs étant couplé avec les électrodes, les dimensions des électrodes et écarts entre elles étant choisis de telle sorte et le circuit d'évaluation (14) étant configuré de sorte à détecter si un objet se déplace à l'avant dans une direction approximativement horizontale, à une vitesse comprise entre 0,2 m/s et 2 m/s à proximité directe des agencements d'électrodes et se rapproche du bord de poignée (6A ; 3), en ce que le circuit d'évaluation détecte d'une part au moins une valeur pour un décalage temporel (Δₜ₁, Δₜ₂) d'une augmentation des capacités de capteurs entre des électrodes (10, 11, 12 ; 10A-H, 11A-H, 12A-H) d'agencements d'électrodes voisins et d'autre part, au moins une valeur pour un taux d'augmentation de la capacité de capteur d'au moins une électrode de chaque agencement d'électrodes et à partir desdites valeurs, détecte un déplacement d'approche approximativement horizontal de la main d'un utilisateur, si premièrement la valeur du taux d'augmentation de la capacité de capteur d'au moins une électrode de chaque agencement d'électrode dépasse une valeur minimale et
si deuxièmement, la valeur réciproque du décalage temporel (Aₜ₁, Δₜ₂) de l'augmentation des capacités de capteurs entre les électrodes (10, 11, 12 ; 10A-H, 11A-H, 12A-H) des agencements d'électrodes (10, 11, 12) voisins, multipliée par l'écart entre les bords des électrodes (10, 11, 12 ; 10A-H, 11A-H, 12A-H) opposés au bord de poignée (6A ; 3) des électrodes des agencements d'électrodes (10, 11, 12) voisins se situe entre 0,2 m/s et 2 m/s.

2. Agencement capacitif de capteurs de proximité selon la revendication 1, **caractérisé en ce que** les agencements d'électrodes sont des électrodes rubans (10, 11, 12) d'une largeur prédéfinie et avec un écart prédéfini.

3. Agencement capacitif de capteurs de proximité selon la revendication 1 ou 2, **caractérisé en ce que** le circuit d'évaluation (14) est configuré de sorte à déterminer par ailleurs au moins une valeur de la courbe de capacité de capteur d'une électrode d'un agencement d'électrodes plus éloigné du bord de poignée (6A ; 3) jusqu'à et après la détection d'une augmentation de la capacité de capteur d'une électrode d'un agencement d'électrodes plus proche du bord de poignée (6A ; 3) et à décider également en fonction de ladite valeur si un objet s'approche du bord de poignée en direction approximativement horizontale, à une vitesse comprise entre 0,2 m/s et 2 m/s.

4. Agencement capacitif de capteurs de proximité selon la revendication 3, **caractérisé en ce que** les agencements d'électrodes sont des électrodes rubans (10, 11, 12) d'une largeur prédéfinie et avec un écart prédéfini et **en ce que** le circuit d'évaluation (14) décide qu'un objet s'approche du bord de poignée en direction approximativement horizontale, à une vitesse comprise entre 0,2 m/s et 2 m/s, si par ailleurs, troisièmement, la valeur de la courbe de la capacité de capteur de l'électrode ruban plus éloignée du bord de poignée (6A ; 3) n'indique pas une chute sensible de la capacité de capteur jusqu'à la détection de l'augmentation de la capacité de capteur de l'électrode ruban plus proche de la poignée.

5. Agencement capacitif de capteurs de proximité selon l'une quelconque des revendications 2 à 4, **caractérisé en ce qu'**au moins trois électrodes rubans (10, 11, 12) approximativement parallèles sont prévues, le circuit d'évaluation (14) évaluant entre autres le décalage temporel et la séquence temporelle des augmentations des capacités de capteurs des trois électrodes rubans.

6. Agencement capacitif de capteurs de proximité selon la revendication 5, **caractérisé en ce qu'**au-dessus des extrémités supérieures des électrodes rubans (10, 11, 12) et avec un écart par rapport à ces dernières est prévue une électrode ruban (13) supplémentaire qui s'étend dans une direction approximativement horizontale et est également couplée avec le circuit d'évaluation (14), le circuit d'évaluation (14) étant configuré de sorte à décider en supplément, en fonction d'au moins une valeur caractérisant la courbe de la capacité de capteur de l'électrode ruban (13) supplémentaire si un objet s'approche du bord de la poignée (6A ; 3) en direction approximativement horizontale.

7. Agencement capacitif de capteurs de proximité selon la revendication 6, **caractérisé en ce que** le circuit d'évaluation (14) est configuré de sorte à décider que l'objet ne s'approche pas du bord de poignée en direction approximativement horizontale, si directement avant une augmentation de l'une des capacités de capteurs des électrodes rubans (10, 11, 12) qui s'étendent à la transversale de la direction de déplacement, une augmentation de la capacité de capteur de l'électrode supplémentaire (13) qui s'étend approximativement dans la direction horizontale qui dépasse une valeur seuil prédéfinie a été détectée.

8. Agencement capacitif de capteurs de proximité selon l'une quelconque des revendications 1 à 7, **caractérisé en ce que** le circuit d'évaluation (14) comporte un microcontrôleur (16) et des circuits qui actionnent les électrodes et qui déterminent dans des intervalles de temps prédéfinis qui représentent une dimension pour la capacité de capteur ou pour ses modifications, sachant que le microcontrôleur (16) traite lesdites valeurs pour générer un signal caractérisant la décision si un objet se déplace dans une direction approximativement horizontale, à une vitesse comprise entre 0,2 m/s et 2 m/s à proximité directe devant les agencements d'électrodes et s'approche du bord de poignée (6A ; 3).
